## Europäisches Patentamt
## European Patent Office
## Office européen des brevets

(11) Veröffentlichungsnummer: **0 397 045**
**A2**

(12) # EUROPÄISCHE PATENTANMELDUNG

(21) Anmeldenummer: **90108434.3**

(51) Int. Cl.⁵: **H01S 3/085, H01S 3/103**

(22) Anmeldetag: **04.05.90**

(30) Priorität: **12.05.89 DE 3915625**

(43) Veröffentlichungstag der Anmeldung:
**14.11.90 Patentblatt 90/46**

(84) Benannte Vertragsstaaten:
**DE FR GB IT NL**

(71) Anmelder: **Standard Elektrik Lorenz Aktiengesellschaft**
**Lorenzstrasse 10**
**D-7000 Stuttgart 40(DE)**

(84) **DE**

Anmelder: **ALCATEL N.V.**
**Strawinskylaan 341 (World Trade Center)**
**NL-1077 XX Amsterdam(NL)**

(84) **FR GB IT NL**

(72) Erfinder: **Lang, J. Robert**
**946 Beverly Way**
**Altadena, CA 91001(US)**
Erfinder: **Mozer, Albrecht**
**Freiberger Strasse 30**
**D-7120 Bietigheim(DE)**

(74) Vertreter: **Pohl, Heribert, Dipl.-Ing et al**
**Standard Elektrik Lorenz AG Patent- und Lizenzwesen Postfach 30 09 29**
**D-7000 Stuttgart 30(DE)**

(54) **Halbleiterlaser.**

(57) Es wird ein DFB (Distributed Feedback)-Laser angegeben, der eine Wellenleiterschicht mit eingeprägtem Liniengitter, das aus zwei oder mehr Untergittern mit unterschiedlichen Gitterkonstanten besteht, aufweist. Das Liniengitter 3 ist entweder frequenz- oder amplitudenmoduliert ausgebildet oder weist eine Mischform beider Arten auf. Durch jedes Untergitter kann eine von der Gitterperiode abhängige Emissionswellenlänge erzeugt werden. Durch Temperaturänderung oder Änderung des Injektionsstromes wird der effektive Brechungsindex verändert, wodurch eine von dem modulierten Liniengitter abhängige Emissionswellenlänge eingestellt werden kann.

Der erfindungsgemäße DFB-Laser wird in der optischen Nachrichtentechnik und speziell im schmalbandigen Wellenlängenmultiplexbetrieb verwendet.

FIG.3A

FIG.3B

## Halbleiterlaser

Die Erfindung betrifft einen Halbleiterlaser gemäß der Oberbegriff von Anspruch 1.

Derartige Halbleiterlaser sind unter dem Begriff DFB (Distributed Feedback)- oder DBR (Distributed Braggreflector)-Laser bekannt und in der EP A2 0 173 269 beschrieben. Derartige Laser weisen zwischen zwei Schichten eine wellenförmige Grenzfläche auf, die ein Gitter bildet, an der stimmuliertes Licht derart gestreut wird, daß sich bei Betrachtung der ersten Ordnung Licht mit einer Emissionswellenlänge λ0 ausbreitet, dessen Wellenlänge der zweifachen Gitterperiode entspricht.

Der Unteschied zwischen einem DFB-Laser und einem DBR-Laser liegt nun darin, daß beim DFB-Laser die wellenförmige Grenzschicht zwischen der laseraktiven Schicht und einer Wellenleiterschicht liegt. Beim DBR-Laser befindet sich die wellenförmige Grenzfläche im Anschluß an die laseraktive Schicht zwischen der Wellenleiterschicht und einer weiteren Schicht mit einem geringeren Brechungsindex. Die bekannten DFB- und DBR-Laser emittieren longitudinal monomociges und extrem schmalbandiges Licht. Diese Laser eignen sich daher sowohl zur optisch kohärenten Nachrichtenübertragung als auch zur optischen Nachrichtenübertragung bei hohen Bitraten über lange Strecken.

Die bekannten DFB- und DBR-Laser weisen nun den Nachteil auf, daß sie nur in einem sehr schmalen Bereich, etwa bis Δλ = 2 nm durchstimmbar sind, und daher im Wellenlängenmultiplexbetrieb nur eingeschränkt verwendet werden können. Die Durchstimmung erfolgt durch Erhöhung der freien Ladungsträgerdichte in der laseraktiven Schicht oder durch Temperaturänderung.

Der Erfindung liegt die Aufgabe zugrunde, einen schmalbandigen Monomoden-Halbleiterlaser zu schaffen, der in einem größeren Wellenlängenbereich Licht emittieren kann.

Die Aufgabe wird bei einer gattungsgemäßen Vorrichtung durch das kennzeichnende Merkmal des Anspruchs 1 gelöst.

Weitere Ausgestaltungen der Erfindung sind dem Rest der Beschreibung und den übrigen Ansprüchen zu entnehmen.

Ausführungsbeispiele werden im folgenden in bezug auf die Figuren 1 bis 3 beschrieben. Es zeigen:

Fig. 1 einen schaltbaren DFB-Laser im Schnitt schematisch,

Fig. 2 einen DFB-Laser mit einem Steuerbereich im Schnitt schematisch und

Fig.3a,b Möglichkeiten der Modulation von zwei Gittern.

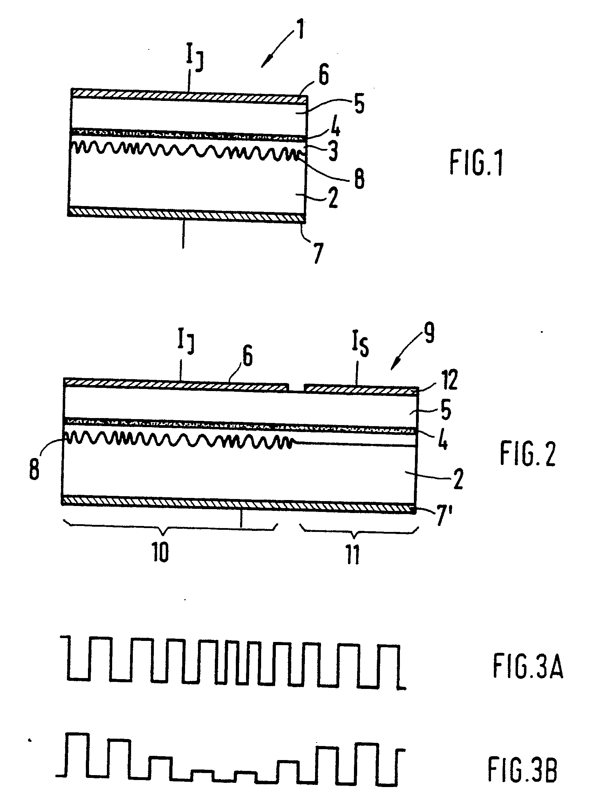

In Fig. 1 ist ein erstes Ausführungsbeispiel eines erfindungsgemäßen DFB- (Distributed Feedback)-Lasers 1 im Schnitt schematisch abgebildet. Auf einem Substrat 2 befindet sich eine Wellenleiterschicht 3, die an die laseraktive Schicht 4 angrenzt. Auf der laseraktiven Schicht 4 befindet sich eine angrenzende Schicht 5, die mit einer Elektrode 6 verbunden ist. Auf der Unterseite des Substrats 2 ist eine zweite Elektrode 7 aufgebracht. Die Grenzfläche zwischen dem Substrat 2 und der Wellenleiterschicht 3 ist wellenförmig ausgebildet, so daß die Wellenleiterschicht auf ihrer Unterseite ein Liniengitter 8 aufweist.

Das Liniengitter besteht aus zwei oder mehreren Untergittern mit unterschiedlichen Gitterkonstanten. In Fig. 3a ist eine mögliche Form eines Liniengitters 8 mit zwei Untergittern abgebildet. Die Gitterzähne sind dabei schematisch als Rechteckzähne abgebildet. Diese Form wird hier als frequenzmodulierte Überlagerung von Untergittern bezeichnet.

Bei einem möglichen Herstellungsverfahren eines solchen Liniengitters wird zuerst das eine Untergitter mit der Gitterkonstante A1 durch holographische Belichtung und anschließendem Ätzen der Wellenleiterschicht 3 in das Substrat 2 eingeprägt. Anschließend wird der gleiche Vorgang für das zweite Untergitter mit der Gitterkonstanten A2 wiederholt. Prinzipiell können dem Liniengitter 8 auf diese Weise noch zusätzliche Untergitter mit weiteren Gitterkonstanten eingeprägt werden.

Bei einem anderen Herstellungsverfahren erfolgt die holographische Belichtung durch mehrmaliges Belichten des Substrats 2 mit Laserlicht unterschiedlicher Wellenlängen und danach durch einmaliges Herausätzen des Liniengitters 8 aus dem Substrat 2.

Eine weitere Form eines Liniengitters 8 ist in Fig. 3b abgebildet. Diese Form wird als amplitudenmodulierte Überlagerung von Untergittern bezeichnet.

Das Liniengitter 8 weist ein erstes Untergitter mit der Gitterkonstanten A1 auf. Ein zweites Untergitter mit der Gitterkonstanten A2 ist nicht direkt, sondern über die Einhüllende der Schwebungsamplitude eingeprägt, die sich aus der Überlagerung zweier Wellen mit den Wellenlängen $\lambda 1 = 2A1n_{eff}/r$ und $\lambda 2 = 2A2n_{eff}/l$ ergibt, wobei r, l ganze Zahlen 1, 2, 3 ... sind und die Ordnung des Gitters beschreiben und $n_{eff}$ den effektiven Brechungsindex darstellt.

Die Herstellung erfolgt nach den oben beschriebenen Verfahren.

Werden im Liniengitter 8 mehr als zwei Untergitter eingeprägt, so ist auch eine Mischform eines amplituden-und frequenzmodulierten Liniengitters 8 möglich.

Bekannte DFB- oder DBR-Laserstrukturen emittieren nur Licht einer Wellenlänge $\lambda 0$, da ihre Liniengitter eine einheitliche Gitterkonstante aufweisen. Der erfindungsgemäße DFB-Laser 1 kann Licht mehrerer Wellenlängen emittieren. Die Anzahl der unterschiedlichen Emissionswellenlängen entspricht der Anzahl der eingeprägten Untergitter. Der DFB-Laser 1 ermittiert Licht der Wellenlänge, welches von der Gitterstruktur her zugelassen ist und am nächsten am Maximum der Verstärkungskurve liegt. Durch Veränderung des Injektionsstromes $I_J$ verändert sich die Konzentration der freien Ladungsträger in der laseraktiven Schicht 4 und somit auch der effektive Brechungsindex. Dieser setzt sich aus den Brechungsindizes der laseraktiven Schicht 4 und der Wellenleiterschicht 3 zusammen. Dies hat zur Folge, daß sich die optischen Verhältnisse im Laserresonator verändern, wodurch der DFB-Laser 1 Licht einer anderen Emissionswellenlänge $\lambda 2$ emittiert.

Durch periodische Änderung des Injektionsstromes $I_J$ kann der DFB-Laser 1 somit im Wellenlängenmultiplexbetrieb verwendet werden oder bei konstantem Injektionsstrom $I_J$, je nach Größe entweder die eine Emissionswellenlänge oder die andere gewählt werden.

In Fig. 2 ist als zweites Ausführungsbeispiel ein weiterer DFB-Laser 9 abgebildet, der die gleiche Schichtenfolge, wie die des DFB-Lasers 1 aus dem ersten Ausführungsbeispiel aufweist. Der schon im Ausführungsbeispiel 1 offenbarte Teil des DFB-Lasers 9 ist im folgenden als Verstärkungsbereich 10 und der sich daran anschließende Teil als Steuerbereich 11 bezeichnet. Der Steuerbereich 11 unterscheidet sich vom Verstärkungsbereich 10 dadurch, daß zwischen dem Substrat 2 und der Wellenleiterschicht 3 kein Liniengitter 8 vorhanden ist. Ferner weist er mit dem Verstärkungsbereich gemeinsam eine Elektrode 7' und eine eigene auf der angrenzenden Schicht 5 befindliche Elektrode 12 auf.

Beim DFB-Laser 9 wird der Injektionsstrom $I_J$ über die Elektrode 6 und der Steuerstrom $I_S$ über die Elektrode 12 eingespeist. Die Brechungsindexänderung erfolgt in diesem Fall nur im Steuerbereich, beeinflußt aber wie beim DFB-Laser 1 von Ausführungsbeispiele 1 den effektiven Brechungsindex, und bewirkt damit eine Änderung der Emissionswellenlänge. Dieses Ausführungsbeispiel 2 hat den Vorteil, daß der Injektionsstrom $I_J$ und der Steuerstrom $I_S$ voneinander unabhängig eingespeist werden können, was ein stabileres Betreiben des DFB-Lasers 9 ermöglicht.

Die Anordnung eines Liniengitters 8 mit mehreren Untergittern unterschiedlicher Gitterkonstanten ist nicht auf den Einsatz in DFB-Lasern beschränkt, sondern kann auch in DBR-Lasern sowie bei Lasern, deren laseraktive Schicht gleichzeitig die Wellenleiterschicht darstellt, eingesetzt werden.

DFB- und DBR-Laser sind an den Lichtaustritsflächen für gewöhnlich entspiegelt, was für die erfindungsgemäße Vorrichtung je nach Anwendungsfall vorgesehen ist. Die Emissionswellenlänge der erfindungsgemäßen Halbleiterlaser lassen sich neben der Variation des Injektionsstromes $I_J$ bzw. des Steuerstroms $I_S$ auch durch die Variation der Temperatur verändern. Hierzu wird das Substrat 2 auf einen regelbaren Wärmeaustauscher aufgebracht (keine Figur).

Die DFB-Laser 1 und 9 weisen jeweils ein n-InP-Substrat 2, eine n-InGaAsP-Wellenleiterschicht 3, eine InGaAsP-laseraktive Schicht 4 und eine p-InP-Schicht 5 auf. Es können auch andere Materialkombinationen verwendet werden, sofern eine Schicht laseraktiv ist.

## Ansprüche

1. Halbleiterlaser mit einer Mehrschichtstruktur, wobei die Grenzfläche zwischen zwei Schichten als Liniengitter ausgebildet ist, und eine der beiden Schichten eine Wellenleiterschicht ist, **dadurch gekennzeichnet,** daß das Liniengitter (8) wenigstens aus zwei unterschiedlichen Untergittern besteht.

2. Halbleiterlaser nach Anspruch 1, dadurch gekennzeichnet, daß die Untergitter amplitudenmoduliert überlagert ausgebildet sind.

3. Halbleiterlaser nach Anspruch 1, dadurch gekennzeichnet, daß die Untergitter frequenzmoduliert überlagert ausgebildet sind.

4. Halbleiterlaser nach Anspruch 1, dadurch gekennzeichnet, daß die Untergitter frequenz- und amplitudenmoduliert ausgebildet sind.

5. Halbleiterlaser nach Anspruch 1, dadurch gekennzeichnet, daß die Emissionswellenlänge ( ) durch Veränderung des Injektionsstromes ($I_J$) zwischen den Elektroden (6, 7) einstellbar ist.

6. Halbleiterlaser nach Anspruch 1, dadurch gekennzeichnet, daß die Wellenleiterschicht (3) neben dem Bereich (10) mit eingeprägtem Liniengitter (8) einen gitterfreien Bereich aufweist, der zwischen zwei Elektroden (12, 7') angeordnet ist und als Steuerbereich (11) wirkt.

7. Halbleiterlaser nach Anspruch 6, dadurch gekennzeichnet, daß im Steuerbereich (11) durch Einspeisung des Steuerstromes ($I_S$) zwischen den Elektroden (12, 7') die Emissionswellenlänge ($\lambda$) veränderbar ist.

8. Halbleiterlaser nach Anspruch 1, dadurch gekennzeichnet, daß er mit einem Wärmeaustauscher gekoppelt ist.

9. Halbleiterlaser nach Anspruch 1, dadurch gekennzeichnet, daß die Emissionswellenlänge ($\lambda$)

über die Veränderung der Temperatur einstellbar ist.

10. Halbleiterlaser nach Anspruch 1, dadurch gekennzeichnet, daß er an den optischen Ausgängen verspiegelt ist.

FIG.1

FIG.2

FIG.3A

FIG.3B